Europäisches Patentamt

(19) European Patent Office

Office européen des brevets

(11) Numéro de publication: **0 242 286
B1**

## (12) FASCICULE DE BREVET EUROPEEN

(45) Date de publication du fascicule du brevet:
18.07.90

(51) Int. Cl.⁵: **G01N 24/08**

(21) Numéro de dépôt: 87400819.6

(22) Date de dépôt: 10.04.87

(54) **Procédé de calibration d'une excitation radiofréquence en expérimentation RMN.**

(30) Priorité: **15.04.86 FR 8605365**

(43) Date de publication de la demande:
**21.10.87 Bulletin 87/43**

(45) Mention de la délivrance du brevet:
**18.07.90 Bulletin 90/29**

(84) Etats contractants désignés:
**DE GB IT NL**

(56) Documents cités:
**EP-A- 0 238 139
GB-A- 2 053 481**

**E. FUKUSHIMA et al.: "Experimental Pulse NMR",
pages 434-437, Addison-Wesley Publishing Co. Inc.,
Reading, US
W. KEMP: "NMR in Chemistry",
pages 119-122, Macmillan Education Ltd, London, GB
PATENT ABSTRACTS OF JAPAN,
vol. 9, no. 253 (P-395)[1976], 11 octobre 1985; &
JP-A-60 104 243 (NIPPON DENSHI K.K.) 08-06-1985**

(73) Titulaire: **GENERAL ELECTRIC CGR S.A., 100, rue
Camille-Desmoulins, F-92130 Issy les Moulineaux(FR)**

(72) Inventeur: **Le Roux, Patrick, THOMSON-CSF
SCPI 19, avenue de Messine, F-75008 Paris(FR)**
Inventeur: **Marilier, Alain, THOMSON-CSF
SCPI 19, avenue de Messine, F-75008 Paris(FR)**

(74) Mandataire: **Ballot, Paul Denis Jacques, Cabinet
Ballot-Schmit 7, rue le Sueur, F-75116 Paris(FR)**

## Description

La présente invention a pour objet un procédé de calibration d'une excitation radiofréquence en expérimentation de résonance magnétique nucléaire, RMN. Les expérimentations de RMN ont pour objet de connaitre la nature intime des corps sans les détruire. En particulier dans le domaine médical les expérimentations RMN sont utilisées, de concert avec des procédés d'imagerie, pour élaborer des images représentatives de coupes de corps de patients soumis à l'examen.

Une expérimentation RMN se pratique dans les conditions suivantes : un corps à examiner est soumis à l'influence d'un champ magnétique continu intense et homogène. Les moments magnétiques des particules du corps tendent alors à s'aligner avec l'orientation du champ magnétique en question. Si on soumet ces particules à une courte excitation radiofréquence, induisant un signal à une fréquence dite de résonance, on peut faire basculer l'orientation de ces moments magnétiques. Lorsque l'excitation cesse, ces moments tendent à reprendre l'orientation initiale en précessant. La fréquence de précession dite fréquence de Larmor est également la fréquence de résonance. Elle est liée à la valeur de l'intensité du champ orienteur par un coefficient $\gamma$ dit rapport gyromagnétique caractéristique du corps. Le signal de précession est capté, on en tire les informations relatives au corps.

Si on reporte, par rapport à l'orientation du champ orienteur, l'inclinaison des moments magnétiques des particules soumises à l'excitation, on remarque que l'amplitude du signal émis en réponse par le corps varie comme le sinus de cet angle. Si l'excitation est une excitation dite à 90°, le signal mesuré en réponse est alors maximum. Aussi, de manière à améliorer le rapport signal à bruit du signal détecté en réponse, il est utile de rechercher qu'elle est l'amplitude de l'excitation qui correspond à une telle modification à 90°de l'orientation du moment magnétique des particules du corps.

Schématiquement on peut dire que pour un corps de nature donnée l'amplitude du champ électromagnétique d'excitation est proportionnelle à l'intensité d'un courant, dit d'antenne, qui passe dans les moyens d'excitation radiofréquence. Soit $B_1$ ce champ d'excitation radiofréquence et $I_a$ le courant d'antenne on peut écire :
$$B_1 = k.I_a$$
Où $\underline{k}$ est un rapport de proportionalité. Au circuit d'adaptation d'antenne près, il apparaît que le courant d'antenne $I_a$ est proportionnel au carré de la tension $V_e$ délivrée par un générateur d'alimentation des moyens d'excitation radiofréquence, divisé par la somme de la résistance d'antenne et de la résistance du corps. Or on sait que la résistance du corps, vis à vis de l'onde électromagnétique qui le pénètre, est proportionnelle, environ à la puissance 5 du diamètre de ce corps. Autrement dit selon que le corps à examiner est celui d'un patient de petite taille (petite résistance) ou au contraire celui d'un patient de grosse taille (grande résistance) la calibration de la tension du générateur s'étale dans une grande plage. Il est connu que la tension du générateur doit être calibrée par exemple entre 50 et 150 Volts. Toutes choses égales par ailleurs, ces considérations sont aussi valables en RMN classique quand on choisit des échantillons de tailles différentes.

Un corps, un patient, étant présent pour examen dans un appareil de RMN la première opération à réaliser consiste alors à calibrer l'excitation à 90° pour se mettre dans les meilleures conditions d'examen possible. Dans les techniques d'examen comportant l'émission d'excitations dites d'écho de spin ou excitations à 180 °, le problème est similaire. Dans ce dernier cas cependant, au lieu de calibrer l'excitation à 90° il est connu pour diverses raisons de calibrer l'excitation à 180° et d'en déduire, par division par deux, l'amplitude de l'excitation à 90°. Dans tout les cas on procéde par expérimentations successives. A chaque expérimentation on mesure l'amplitude du signal détécté. On fait ainsi varier la tension du générateur depuis une première valeur, par exemple inférieure à une première valeur donnée connue comme étant une limite basse pour des corps très petits, jusqu'à une deuxième valeur par exemple supérieure à une deuxième valeur donnée connue comme nécessaire à l'excitation de grands corps. On relève la courbe de l'amplitude du signal reçu en fonction des expérimentations et on en déduit, à son maximum, la valeur recherchée pour obtenir une excitation calibrée.

Pour approcher ce maximum avec le plus de précision possible, il est nécessaire de faire évoluer l'amplitude d'excitation avec un pas assez fin. La finesse de ce pas, dans un exemple de l'ordre de 0,5 volts, eu égard à la largeur de la plage à explorer, fait durer l'opération de calibration trop longtemps. Par exemple au delà de 20 secondes l'utilisateur commence à soupçonner un défaut de fonctionnement de l'appareil. Il est donc nécessaire d'aller vite. Or pour différentes raisons liées au phénomène RMN les expérimentations successives ne peuvent être menées à un rythme aussi élevé que désiré. Au contraire elles doivent être séparées dans le temps les unes des autres d'un temps égal ou supérieur à un temps, dit de relaxation $T_1$, caractéristique du milieu à étudier. Dans le domaine médical $T_1$ vaut de l'ordre de 500 millisecondes.

Pour raccourcir les phases de calibration il a d'abord été envisagé de ne pas explorer toute la gamme mais de s'arrêter dès que le maximum du signal de réception a été repéré et que, dans les expérimentations successives, son amplitude continue à baisser. Par ailleurs, dans d'autres voies d'investigation, il a été imaginé de proposer des sous-plages, censées convenir à un grand nombre de patients tout en réduisant notablement l'amplitude de la plage. La calibration s'effectue alors sur ces sous-plages en un nombre limité d'expérimentations, par exemple 16. Si le maximum n'a pas été trouvé dans une sous-plage la calibration en entier est réentreprise en partant d'une extrémité de la plage. L'intérêt de ce type de procédure est minime. En définitive le nombre d'échecs de cette exploration simplifiée est encore trop important pour en justifier l'emploi.

On connaît comme état de la technique, au sens de l'article 54.3 de la Convention sur le Brevet Européen, un document EP-A 0 238 139 qui traite de ces questions. Cependant, ce document ne décrit pas une approche progressive avec une précision constante de la détermination de la valeur de l'amplitude. En conséquence, des pertes de temps sont induites.

L'invention propose de remédier à cet inconvénient de perte de temps pendant la calibration par l'emploi d'une procédure particulière de répartition des amplitudes des excitations. L'invention part du principe que, comme pour le passage d'une excitation à 90° à une excitation à 180° il est nécessaire de multiplier l'amplitude par deux, la précision de la détermination de la valeur de l'amplitude d'une excitation à 90°, ou à 180°, s'exprime en une proportion de cette amplitude. Il en a été déduit alors que, pour une précision donnée de la calibration, la variation d'amplitude d'une expérimentation à l'autre ne devait pas être à pas constant mais à pas progressif. Par ailleurs compte tenu de la variation de la résistance du corps selon la puissance 5 du diamètre de ce corps il a même pu être déterminé que la progression de la variation de l'amplitude de l'excitation devait être une progression géométrique, de raison donnée par la valeur de la précision recherchée. Dans un exemple où un défaut de plus ou moins 7° est toléré sur une impulsion à 180°, on a ainsi pu déterminer que la progression géométrique, en croissant, valait 1,08.

L'invention a pour objet un procédé de calibration d'une excitation radiofréquence en expérimentation RMN comportant les phases suivantes :
- on excite par une excitation radiofréquence d'une amplitude donnée un corps à soumettre à cette expérimentation,
- on mesure la réponse émise en retour par le corps,
- on fait varier un certain nombre de fois l'amplitude de l'excitation et on réitère à chaque fois les deux premières phases,
- on détermine l'amplitude de l'excitation la plus adéquate à la conduite de l'expérimentation, caractérisé en ce que
- on fait varier l'amplitude d'une manière monotone en modifiant progressivement d'une fois à l'autre la valeur de la variation d'amplitude.

L'invention sera mieux comprise à la lecture de la description qui suit et à l'examen des figures qui l'accompagnent. Celles ci ne sont données qu'à titre indicatif et nullement limitatif de l'invention. Elles représentent :

- figure 1 la représentation schématique d'un appareil de RMN dans lequel est mis en oeuvre le procédé selon l'invention;

- figures 2a à 2d des diagrammes montrant des valeurs de signaux RMN détectés en fonction de la tension du générateur d'excitation radiofréquence.

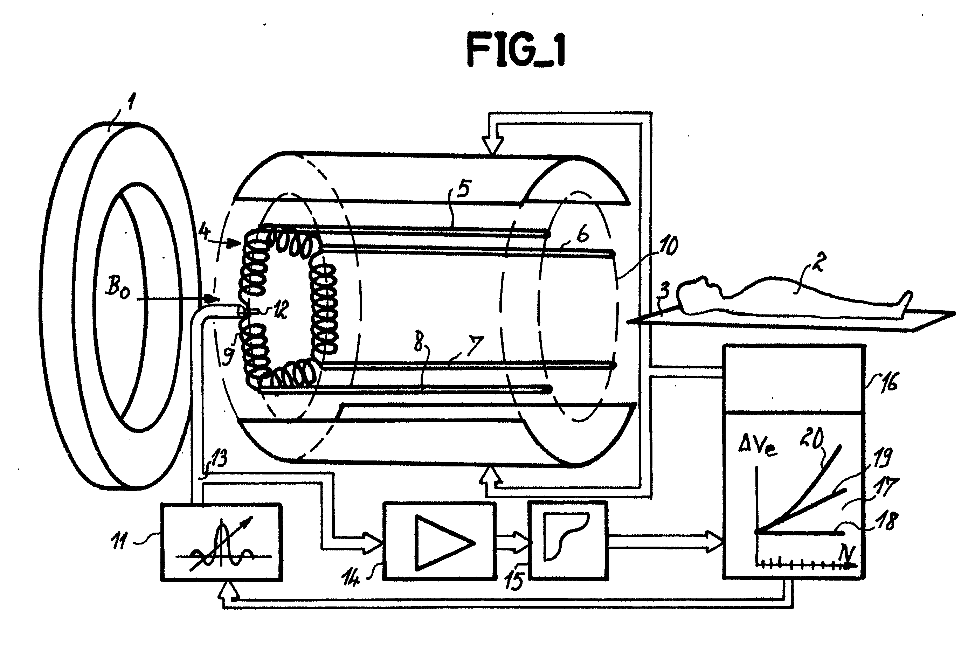

La figure 1 représente un appareil de RMN dans lequel est mis en oeuvre le procédé de calibration de l'invention. Cet appareil comporte essentiellement des premiers moyens 1 pour produire un champ orientateur $B_0$ dans lequel doit être plongé un corps 2 reposant, par exemple, sur un plateau mobile 3. Cet appareil comporte une antenne résonnante 4. Celle ci est munie dans un exemple de barres conductrices 5 à 8 excitées au moyen d'un circuit résonnant 9, et disposées à la périphérie d'un cylindre fictif 10 à l'intérieur duquel doit être approché le corps 2. Un générateur 11 produisant une excitation d'amplitude variable et couplé par des moyens, par exemple tels que 12, au circuit résonnant 9. Lorsque l'excitation est terminée l'antenne 4 peut servir à la réception du signal de résonance. Ce signal est orienté par un duplexeur 13 sur un récepteur 14. Le signal reçu est traité dans un circuit de traitement 15. Généralement l'appareil RMN est piloté par un séquenceur 16 qui détermine l'organisation des séquences de mesure.

Ce séquenceur, dans l'invention, effectue une fonction supplémentaire. Cette fonction supplémentaire, représentée schématiquement par le diagramme 17 de sa fonction de transfert, consiste à connaître le numéro d'ordre N de l'expérience de calibration qui vient d'être entreprise, à aller rechercher dans une mémoire une variation d'amplitude $\Delta V_e$ de l'excitation correspondant à ce numéro d'ordre, et à affecter comme amplitude d'excitation pour l'expérience d'ordre suivant la valeur précédente de cette amplitude augmentée de la variation trouvée. Dans l'état de la technique le diagramme de variation d'amplitude en fonction du numéro d'ordre de l'expérience était une courbe horizontale 18:$\Delta V_e$ était constant. Dans l'invention ce diagramme montre une certaine progressivité. On pourrait choisir une progression de type arithmétique 19: d'une expérience à l'autre la modification de la variation d'amplitude serait constante. Dans ce cas la valeur de la variation suivrait linéairement l'ordre de l'expérience.

Dans l'invention d'une manière préférée on maintient la précision de l'appréciation de la valeur calibrée recherchée. Il en résulte que la variation d'amplitude de l'excitation d'une expérience à l'autre, doit suivre une progression géométrique. De ce fait, les variations croissant plus fortement, la valeur extrême de la gamme est atteinte plus rapidement. En effet, si les variations d'amplitude suivent une courbe 20 préconisée par une progression géométrique, le nombre d'expériences nécessaires pour balayer toute la gamme sera inférieur à celui correspondant à l'utilisation de la courbe linéaire 19 et en tout cas notablement inférieur au nombre correspondant à la constance de variation de la courbe 18. Par exemple dans l'exemple de l'état de la technique cité, où une gamme de 100 volts (50 volts à 150 volts) était explorée avec un pas de 0,5 volts, il pouvait être nécessaire d'effectuer 200 expériences successives. A 500 milisecondes par expérience la calibration entière dure plus d'une minute. Dans l'invention on a pu mesurer que dans les cas les plus défavorables le nombre d'expérimentations nécessaires se réduisaient à une quinzaine. Ceci conduit à une durée de calibration de l'ordre de 8 secondes.

La description de la fonction de transfert 17 exécutée par l'ordinateur du séquenceur 16 correspond à une exploration de la gamme de $V_e$ avec des va-

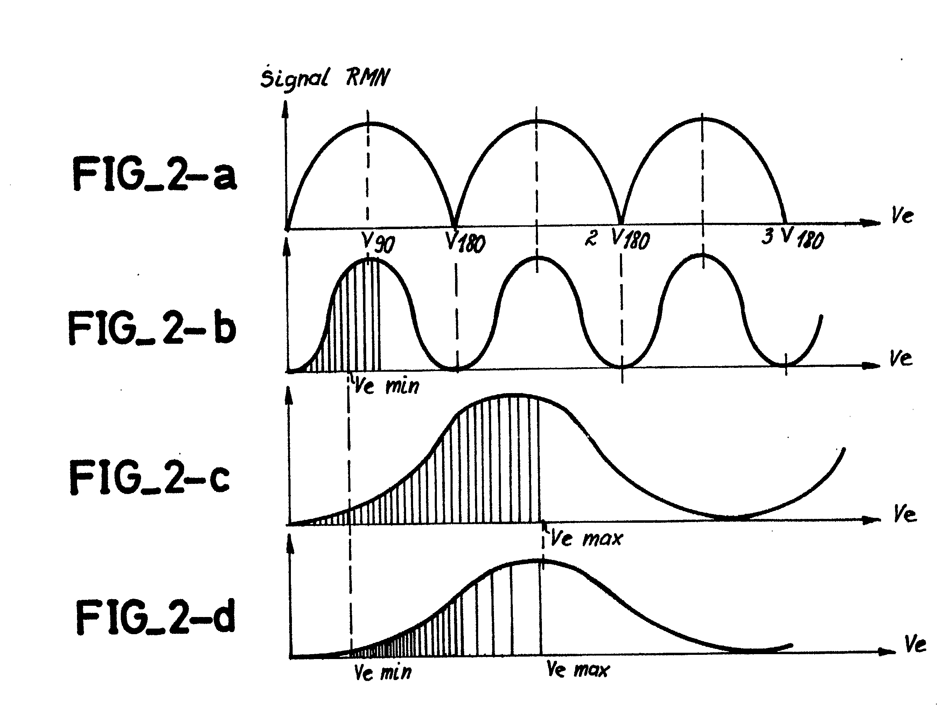

leurs croissantes. Les instructions de modification de l'amplitude de l'excitation sont appliquées au générateur 11. La figure 2 montre à quel type d'investigation correspond cette croissance de la variation d'amplitude pour la calibration. On en déduira ultérieurement que la gamme balayée peut être explorée en partant de la valeur supérieure, et en décroissant progressivement la valeur de variation d'amplitude (selon une progession géométrique de raison inférieure à 1, et inverse de la raison précédente). La figure 2a montre l'amplitude redressée du signal de RMN reçu sur le récepteur 14 en fonction de la valeur de la tension de l'excitation. Elle est nulle, ou théoriquement nulle, lorsque les moments magnétiques ont été tournés de 180°. Cette allure se repète cycliquement pour toutes les valeurs de $V_e$ multiples d'une valeur $V_{180}$ correspondant à l'annulation de ce signal de RMN. Les figures 2b et 2c montrent ce qu'il advient de cette allure du signal de RMN après qu'il a subit une détection quadratique et selon respectivement qu'il correspond à une calibration d'excitation pour un petit corps, un petit patient, ou un grand corps, un grand patient. Le nombre des traits dans ces graphes montre à chaque fois le nombre d'expériences de calibration entreprises pour déterminer l'amplitude de l'excitation $V_{90}$ qui lui correspond. Les variations d'amplitude d'excitation d'une expérience à l'autre, dans les deux cas, sont égales. Dans les deux cas les expériences sont arrêtées après que le maximum du signal détecté à été trouvé.

Dans l'invention on repère une valeur $V_{e\,min}$ inférieure à l'amplitude de l'excitation $V_{90}$ correspondant au plus petit corps susceptible d'être soumis à l'examen de RMN. Dans un exemple dans le domaine médical ce petit corps correspond à celui d'un enfant. Puis on repère également une valeur $V_{e\,max}$ supérieure à l'amplitude d'excitation $V_{90}$ relative au plus gros corps examinable. On sait alors que l'amplitude de calibration recherchée doit se trouver entre $V_{e\,min}$ et $V_{e\,max}$. On procède alors à une exploration systématique de cette plage en commençant par une extrémitée. Dans l'exemple décrit on a choisi l'extrémité de la plage correspondant au petit corps. On aurait pu tout aussi bien choisir celle correspondant au plus gros corps. D'une expérience à l'autre la variation d'amplitude se modifie : les expériences sont plus proches les unes des autres en amplitude, pour des faibles valeurs d'excitation que vers les fortes valeurs. Le nombre des expériences nécessaires pour trouver le maximum est inférieur, dans la figure 2 d, à celui de la figure 2 c. On arrête également l'exploration quand le maximum a été trouvé.

**Revendications**

1 - Procédé de calibration d'une excitation radiofréquence en expérimentation (1-3) RMN comportant les phases suivantes :
- on excite (7-12) par une excitation radiofréquence d'amplitude donnée un corps (2) à soumettre à cette expérimentation,
- on mesure (14) la réponse émise en retour par le corps,
- on fait varier (16) un certain nombre de fois l'amplitude de l'excitation et on réitère à chaque fois les deux premières phases;
- on détermine l'amplitude ($V_{90}$) de l'excitation la plus adéquate à la conduite de l'expérimentation,
- caractérisé en ce que
- on fait varier (18-19) l'amplitude d'une manière monotone en modifiant progressivement d'une fois (N) à l'autre la valeur ($\Delta Ve$) de la variation de l'amplitude.

2 - Procédé selon la revendication 1 caractérisé en ce que pour faire varier on choisit une valeur initiale ($V_{e\,min}$) d'amplitude juste extérieure à un domaine de valeur d'amplitude d'excitation qui correspond à l'éventail des divers corps à examiner.

3 - Procédé selon la revendication 1 ou selon la revendication 2 caractérisé en ce que la progression est une progression géométrique (20).

4 - Procédé selon la revendication 3 caractérisé en ce que la progression géométrique est croissante de raison 1,08.

5 - Procédé selon la revendication 3 caractérisé en ce que la progression géométrique est décroissante de raison 0,926.

6 - Procédé selon la revendication 2, dans lequel la mesure de la réponse varie d'une manière monotone donnée en fonction de la suite des expériences, caractérisé en ce qu'on arrête la calibration quand la mesure de la reponse commence à varier d'une manière monotone inverse.

**Patentansprüche**

1. Verfahren zur Kalibrierung einer experimentellen RMN-Funkfrequenz-Erregung (1–3), mit den folgenden Phasen:
– man erregt (7–12) einen Körper (2), der diesem Experiment unterworfen werden soll, durch eine Funkfrequenz-Erregung einer gegebenen Amplitude,
– man mißt (14) die von dem Körper zurückgegebene Antwort,
– man variiert (16) eine bestimmte Anzahl von Malen die Amplitude der Erregung, und man wiederholt jeweils die beiden ersten Phasen,
– man bestimmt die Amplitude ($V_{90}$) der Erregung, die für die Durchführung des Experiments am besten geeignet ist, dadurch gekennzeichnet, daß:
– die Amplitude gleichmäßig variiert wird (18–19), indem von Mal (N) zu Mal der Wert ($\Delta Ve$) der Amplitudenvariation progressiv verändert wird.

2. Verfahren nach Anspruch 1, dadurch gekennzeichnet, daß für die Variation ein Amplituden-Anfangswert ($V_{e\,min}$) gewählt wird, der gerade außerhalb eines Amplitudewertbereichs für die Erregung liegt, der der Auswahl der verschiedenen, zu untersuchenden Körper entspricht.

3. Verfahren nach Anspruch 1 oder 2, dadurch gekennzeichnet, daß die Progression eine geometrische Reihe (20) ist.

4. Verfahren nach Anspruch 3, dadurch gekennzeichnet, daß die geometrische Reihe mit 1,08 anwächst.

5. Verfahren nach Anspruch 3, dadurch gekennzeichnet, daß die geometrische Reihe mit 0,926 abnimmt.

6. Verfahren nach Anspruch 2, in welchem der Meßwert der Antwort monoton in einer Weise variiert, die in Abhängigkeit von der Folge von Experimenten gegeben ist, dadurch gekennzeichnet, daß die Kalibrierung beendet wird, wenn der Meßwert der Antwort beginnt, umgekehrt monoton zu variieren.

## Claims

1 A method for radio frequency excitation NMR testing (1–3) comprising the following phases
   – a body (2) to be subjected to such testing is excited (7–12) with a radio frequency excitation having a given amplitude,
   – the return response emitted by the body is measured (14),
   – the amplitude of excitation is varied (16) a certain number of times over and each time the two first phases are reiterated;
   – the amplitude ($V_{90}$) of excitation is ascertained which is best suited to the conduct of the testing,
   – characterized in that
   – the amplitude is varied (18–19) in a uniform manner by progressively modifying from time (N) to time the value ($\Delta V_e$) of the variation in amplitude.

2 The method as claimed in claim 1, characterized in that in order to perform variation an initial value ($V_{e\ min}$) amplitude is selected just outside a range of excitation amplitude values which correspond to the set of the various bodies to be examined.

3 The method as claimed in claim 1 or as in claim 2, characterized in that the progression is a geometrical progression (20).

4 The method as claimed in claim 3, characterized in that the geometrical progression has an increment ratio of 1.08.

5 The method as claimed in claim 3, characterized in that the geometrical progression has an increment ratio of 0.926.

6 The method as claimed in claim in which the measure of the response varies in a given uniform manner as a function of the sequence of tests, characterized in that the calibration is halted when the measure of response commences to vary in a uniform inverse manner.

# FIG_1

EP 0 242 286 B1

FIG_2-a

FIG_2-b

FIG_2-c

FIG_2-d

Signal RMN

Ve

Ve

Ve

Ve

V 90
V 180
2 V 180
3 V 180

Ve min

Ve min

Ve max

Ve min

Ve max

EP 0 242 286 B1